# EUROPEAN PATENT SPECIFICATION

(11) **EP 4 246 582 B1**
(45) Date of publication and mention of the grant of the patent: **03.09.2025**
(21) Application number: 21903007.9
(22) Date of filing: 14.10.2021
(51) Int. Cl.: H10F 39/15, H10F 39/12, H10D 44/45, H10F 39/00

(54) **PHOTOELECTRIC CONVERSION DEVICE**
PHOTOELEKTRISCHE UMWANDLUNGSVORRICHTUNG
DISPOSITIF DE CONVERSION PHOTOÉLECTRIQUE

(30) Priority: 07.12.2020 JP 2020202498
(43) Date of publication of application: 20.09.2023
(73) Proprietor: Hamamatsu Photonics K.K., Hamamatsu-shi, Shizuoka 435-8558 (JP)
(72) Inventor: TAKAGI, Shin-ichiro, Hamamatsu-shi, Shizuoka 435-8558 (JP); YAMADA, Atsunori, Hamamatsu-shi, Shizuoka 435-8558 (JP)
(74) Representative: Hoffmann Eitle
(86) International application number: PCT/JP2021/038083
(87) International publication number: WO 2022/123903

(56) References cited:
- WO-A1-2017/073524
- JP-A- 2002 325 720
- JP-A- 2003 009 000
- JP-A- 2003 051 510
- JP-A- 2003 158 679
- JP-A- 2007 318 005
- JP-A- 2010 177 587
- JP-A- 2010 177 588
- JP-A- 2010 177 590
- JP-A- 2011 243 641
- JP-A- S5 556 659
- US-A1- 2009 284 632
- US-A1- 2011 186 913
- US-A1- 2020 212 098

## Description

### Technical Field

The present disclosure relates to a photoelectric conversion device.

### Background Art

As a conventional photoelectric conversion device, Patent Literature 1 describes a solid-state imaging device as follows. That is, the solid-state imaging device described in Patent Literature 1 includes an imaging region that generates electric charge according to incidence of light, and a transfer part (specifically, a vertical shift register, a horizontal shift register, a corner register, and a multiplication register) that transfers the electric charge generated in the imaging region. In the solid-state imaging device described in Patent Literature 1, the horizontal shift register, the corner register, and the multiplication register extend to be bent in the curved corner register.

### Citation List

### Patent Literature

[Patent Literature 1] Japanese Unexamined Patent Publication No. 2010-177588

US 2011/186913, US 2020/212098 and US 2009/284632 describe solid state imaging device according to the prior art.

### Summary of Invention

### Technical Problem

In the solid-state imaging device described in Patent Literature 1, the corner register includes a plurality of transfer electrodes. Here, if the number of transfer electrodes of the corner register is reduced, since a difference between an inner width and an outer width in each transfer electrode increases, there is a likelihood that transfer of electric charge on an outer side of each transfer electrode will be insufficient. In order to avoid that, if the number of transfer electrodes of the corner register is increased, the following problems may arise. That is, since an inner width of each transfer electrode becomes smaller, there is a likelihood that a structure thereof will be complicated and a yield thereof will decrease. Also, if the number of transfer electrodes of the corner register is large, there is a likelihood that high-speed driving will be hindered due to increase in electrical capacity, or power consumption will increase.

An objective of the present disclosure is to provide a photoelectric conversion device capable of reliably transferring electric charge while avoiding increase in the number of transfer electrodes in such a case in which a direction of electric charge transfer or the like is changed in a transfer part.

### Solution to Problem

A photoelectric conversion device according to one aspect of the present disclosure includes a photoelectric conversion part configured to generate electric charge according to incidence of light, and a transfer part configured to transfer the electric charge, in which the transfer part includes a first transfer region configured to transfer the electric charge along a first line, a second transfer region configured to transfer the electric charge along a second line, a third transfer region configured to transfer the electric charge from the first transfer region side to the second transfer region side along a third line connected to the first line and the second line, a first transfer electrode disposed on the first transfer region, and a second transfer electrode disposed on the second transfer region, the third line is deviated from at least one of the first line and the second line, the third transfer region includes a first semiconductor region having a first impurity concentration, and a second semiconductor region having a second impurity concentration higher than the first impurity concentration, the second semiconductor region extends along the third line to be widened on the second transfer region side, and the first semiconductor region is disposed on both sides of the second semiconductor region in a direction in which the second semiconductor region is widened.

In the photoelectric conversion device according to one aspect of the present disclosure, the transfer part includes the first transfer region configured to transfer electric charge along a first line, the second transfer region configured to transfer the electric charge along a second line, and the third transfer region configured to transfer the electric charge from the first transfer region side to the second transfer region side along a third line connected to the first line and the second line, and the third line is deviated from at least one of the first line and the second line. Thereby, a direction of electric charge transfer or the like is changed in at least the third transfer region. In the third transfer region, the second semiconductor region having the second impurity concentration higher than the first impurity concentration extends along the third line to be widened on the second transfer region side, and the first semiconductor region having the first impurity concentration is disposed on both sides of the second semiconductor region in a direction in which the second semiconductor region is widened. Thereby, an electric potential gradient (potential energy gradient) in which electric charge moves from the first transfer region side to the second transfer region side along the third line is formed in the third transfer region. Therefore, it is unnecessary to dispose a large number of transfer electrodes on the third transfer region to change a direction of electric charge transfer or the like. Therefore, according to the photoelectric conversion device of one aspect of the present disclosure, in such a case in which a direction of electric charge transfer or the like is changed in the transfer part, the electric charge can be reliably transferred while avoiding increase in the number of transfer electrodes.

In the photoelectric conversion device according to one aspect of the present disclosure, a direction in which the second transfer region transfers the electric charge along the second line may be different from a direction in which the first transfer region transfers the electric charge along the first line. According to this, a direction of electric charge transfer can be changed in the transfer part.

In the photoelectric conversion device according to one aspect of the present disclosure, the third line may be a curve. According to this, a direction of electric charge transfer can be smoothly changed in the transfer part.

In the photoelectric conversion device according to one aspect of the present disclosure, the transfer part may further include a third transfer electrode disposed on the third transfer region. According to this, since not only electric potentials of the first transfer region and the second transfer region but also an electric potential of the third transfer region can be controlled, the electric charge can be more reliably transferred.

In the photoelectric conversion device according to one aspect of the present disclosure, the transfer part may further include a buried layer having a conductivity type different from conductivity types of the first semiconductor region and the second semiconductor region, and the buried layer may be disposed on the third transfer region. According to this, since it is not necessary to dispose a transfer electrode on the third transfer region, the configuration can be simplified. Also, generation of a dark current in the third transfer region can be suppressed.

The photoelectric conversion device according to one aspect of the present disclosure may further include a light-shielding layer disposed on an incident side of light with respect to the transfer part. According to this, unnecessary electric charge generated in the transfer part due to incidence of light on the transfer part can be prevented.

### Advantageous Effects of Invention

According to the present disclosure, it is possible to provide a photoelectric conversion device capable of reliably transferring electric charge while avoiding increase in the number of transfer electrodes in such a case in which a direction of electric charge transfer or the like is changed in a transfer part.

### Brief Description of Drawings

FIG. 1 is a plan view of a photoelectric conversion device according to one embodiment.
FIG. 2 is a cross-sectional view of the photoelectric conversion device along line II-II illustrated in FIG. 1.
FIG. 3 is a plan view of a transfer part illustrated in FIG. 1.
FIG. 4 is a cross-sectional view of the transfer part along line IV-IV illustrated in FIG. 3.
FIG. 5 is a cross-sectional view of the transfer part along line V-V illustrated in FIG. 3.
FIG. 6 is a view for explaining a principle in which an electric potential gradient is formed in a third transfer region illustrated in FIG. 3.
FIG. 7 is a potential energy diagram of the transfer part illustrated in FIG. 3.
FIG. 8 is a potential energy diagram of the transfer part illustrated in FIG. 3.
FIG. 9 is a potential energy diagram of the transfer part illustrated in FIG. 3.
FIG. 10 is a cross-sectional view of a photoelectric conversion device according to a modified example.
FIG. 11 is a cross-sectional view of a transfer part illustrated in FIG. 10.
FIG. 12 is a plan view of the transfer part of the modified example.
FIG. 13 is a cross-sectional view of the transfer part along line XIII-XIII illustrated in FIG. 12.
FIG. 14 is a cross-sectional view of the transfer part along line XIV-XIV illustrated in FIG. 12.
FIG. 15 is a plan view of the transfer part of the modified example.
FIG. 16 is a plan view of the transfer part of the modified example.
FIG. 17 is a plan view of the transfer part of the modified example.
FIG. 18 is a plan view of the transfer part of the modified example.
FIG. 19 is a plan view of the transfer part of the modified example.
FIG. 20 is a potential energy diagram of the transfer part illustrated in FIG. 12.
FIG. 21 is a potential energy diagram of the transfer part illustrated in FIG. 12.
FIG. 22 is a potential energy diagram of the transfer part illustrated in FIG. 12.

### Description of Embodiments

Hereinafter, an embodiment of the present disclosure will be described in detail with reference to the drawings. Further, in each of the drawings, the same or corresponding portions will be denoted by the same reference signs, and duplicate description thereof will be omitted.

### [Configuration of photoelectric conversion device]

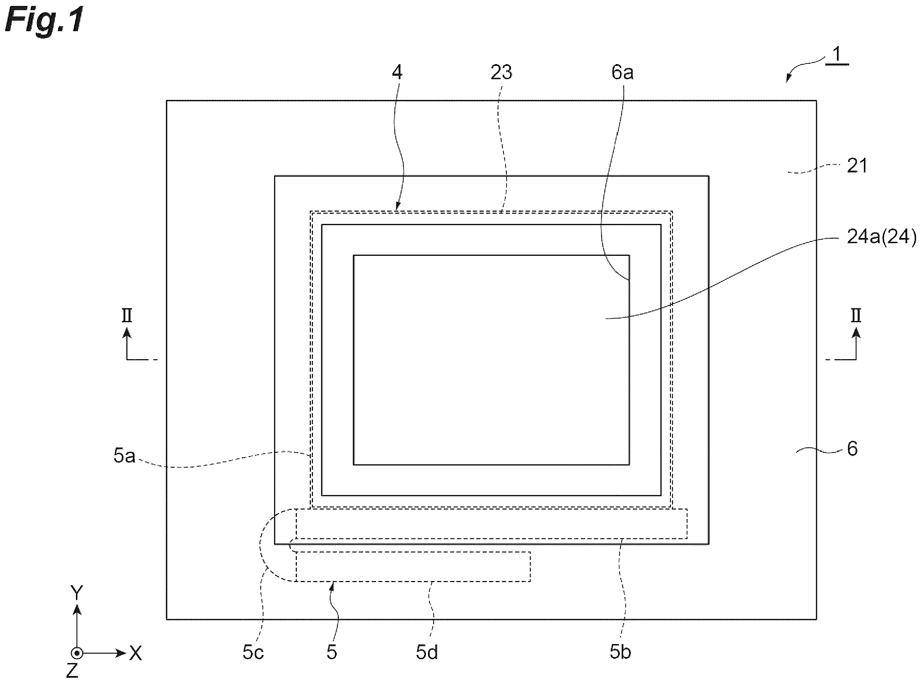

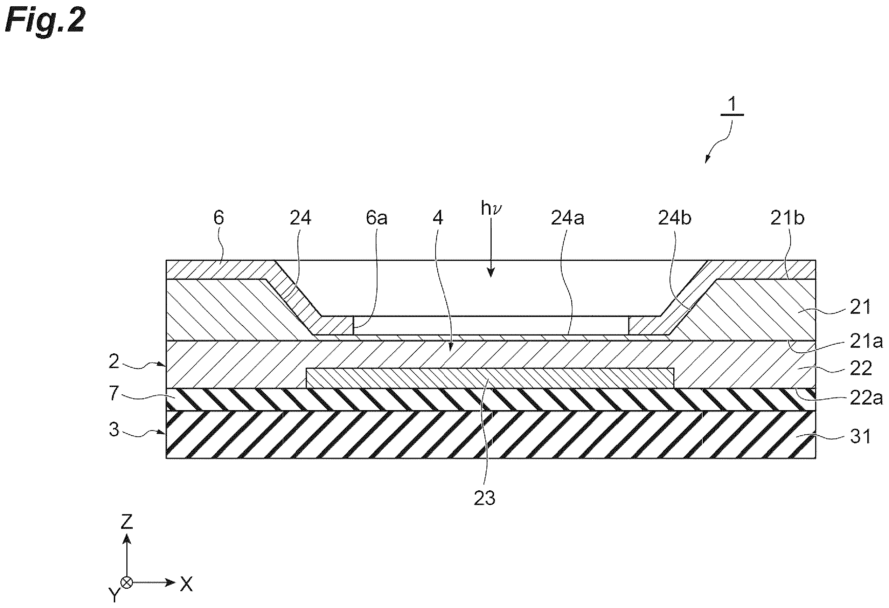

As illustrated in FIGS. 1 and 2, a photoelectric conversion device 1 includes a semiconductor layer 2 and a wiring layer 3. A photoelectric conversion part 4 generating electric charge according to incidence of light hv is provided in the semiconductor layer 2. As a transfer part 5 for transferring electric charge, a vertical shift register 5a, a horizontal shift register 5b, a corner register 5c, and a multiplication register 5d are provided in the semiconductor layer 2 and the wiring layer 3. The photoelectric conversion device 1 is, for example, a back-illuminated solid-state imaging device in which a CCD-type imaging region is configured by the photoelectric conversion part 4 and the vertical shift register 5a. Hereinafter, a thickness direction of the semiconductor layer 2 is referred to as a Z-axis direction, one direction perpendicular to the Z-axis direction is referred to as an X-axis direction, and a direction perpendicular to both the Z-axis direction and the X-axis direction is referred to as a Y-axis direction.

The semiconductor layer 2 includes a semiconductor substrate 21, a semiconductor layer 22, and a semiconductor region 23. The semiconductor substrate 21 is, for example, a P⁺-type silicon substrate. The semiconductor layer 22 is, for example, a P⁻-type silicon layer formed on a surface 21a of the semiconductor substrate 21 by epitaxial growth. The semiconductor region 23 is, for example, an N⁺-type semiconductor region formed in the semiconductor layer 22 along a surface 22a of the semiconductor layer 22 by being doped with N-type impurities.

Further, "P⁺-type" means that a concentration of P-type impurities is high such as, for example, a concentration of P-type impurities being 1×10¹⁷ cm⁻³ or higher, and "P⁻-type" means that a concentration of P-type impurities is low such as, for example, a concentration of P-type impurities being 1×10¹⁵ cm⁻³ or lower. The same applies to N-type impurities.

A recessed part 24 is formed on a back surface 21b of the semiconductor substrate 21. The recessed part 24 is formed by, for example, etching and has a truncated quadrangular pyramid shape that widens toward a side of the semiconductor substrate 21 opposite to the surface 21a side. In the photoelectric conversion device 1, a PN junction region formed in a portion of the semiconductor layer 22 corresponding to a bottom surface 24a of the recessed part 24 constitutes the photoelectric conversion part 4.

A light-shielding layer 6 is formed on the back surface 21b of the semiconductor substrate 21 and a side surface 24b of the recessed part 24. The light-shielding layer 6 has an opening 6a corresponding to the bottom surface 24a of the recessed part 24. The light-shielding layer 6 is, for example, a metal film formed on the back surface 21b and the side surface 24b by vapor deposition or sputtering. In the photoelectric conversion device 1, the light hv is incident on the photoelectric conversion part 4 from the back surface 21b side of the semiconductor substrate 21 via the opening 6a of the light-shielding layer 6 and the bottom surface 24a of the recessed part 24.

The wiring layer 3 is formed on the surface 22a of the semiconductor layer 22 with an insulating film 7 interposed therebetween. The wiring layer 3 includes a plurality of transfer electrodes (not illustrated) and an interlayer insulating film 31. The insulating film 7 is, for example, an SiO₂ film. The interlayer insulating film 31 is, for example, a BPSG film.

The vertical shift register 5a includes a plurality of transfer electrodes disposed at a portion of the wiring layer 3 corresponding to the photoelectric conversion parts 4. The vertical shift register 5a transfers electric charge generated in the photoelectric conversion part 4 to one side in the Y-axis direction.

The horizontal shift register 5b extends in the X-axis direction on one side of the vertical shift register 5a in the Y-axis direction. The horizontal shift register 5b includes a plurality of transfer electrodes aligned in the X-axis direction. The horizontal shift register 5b transfers the electric charge transferred by the vertical shift register 5a to one side (left side in FIG. 1) in the X-axis direction.

The corner register 5c is disposed on one side of the horizontal shift register 5b in the X-axis direction. The corner register 5c transfers the electric charge transferred by the horizontal shift register 5b, and changes a direction of transferring the electric charge from one side (left side in FIG. 1) to the other side (right side in FIG. 1) in the X-axis direction.

The multiplication register 5d extends in the X-axis direction on one side of the horizontal shift register 5b in the Y-axis direction. The multiplication register 5d includes a plurality of transfer electrodes aligned in the X-axis direction. The multiplication register 5d multiplies the electric charge (electrons) while transferring the electric charge transferred by the corner register 5c to the other side (right side in FIG. 1) in the X-axis direction. The electric charge transferred by the multiplication register 5d are output to the outside through an amplifier formed in the semiconductor layer 22.

The horizontal shift register 5b, the corner register 5c, and the multiplication register 5d are covered with a frame portion surrounding the recessed part 24 of the semiconductor substrate 21 and the light-shielding layer 6 when viewed from an incident side of the light hv. That is, in the photoelectric conversion device 1, the frame portion of the semiconductor substrate 21 and the light-shielding layer 6 are disposed on the incident side of the light hv with respect to the horizontal shift register 5b, the corner register 5c, and the multiplication register 5d.

### [Configuration of transfer part]

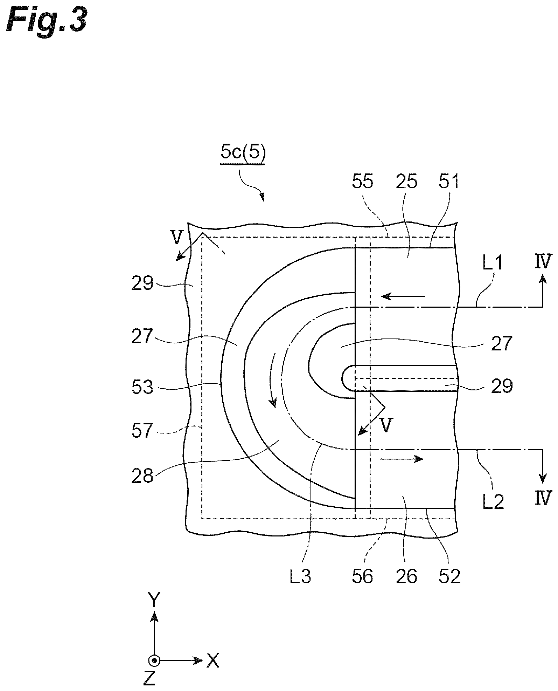

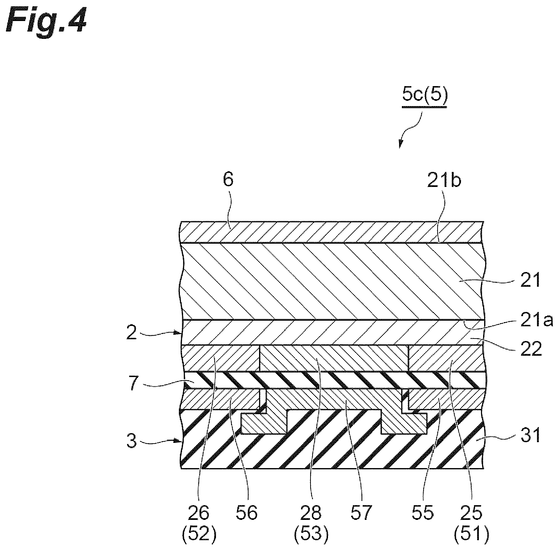

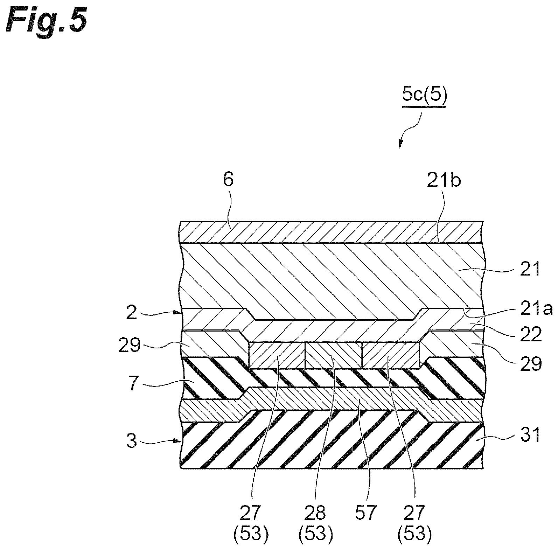

A configuration of a portion of the transfer part 5 corresponding to the corner register 5c will be described in detail with reference to FIGS. 3, 4, and 5. FIG. 3 is a plan view of the transfer part 5 (specifically, a portion of the transfer part 5 corresponding to the corner register 5c) illustrated in FIG. 1. FIG. 4 is a cross-sectional view of the transfer part 5 along IV-IV line illustrated in FIG. 3, and FIG. 5 is a cross-sectional view of the transfer part 5 along V-V line illustrated in FIG. 3.

As illustrated in FIGS. 3, 4, and 5, the transfer part 5 includes a first transfer region 51, a second transfer region 52, a third transfer region 53, a first transfer electrode 55, a second transfer electrode 56, and a third transfer electrode 57. The first transfer region 51, the second transfer region 52, and the third transfer region 53 are formed in the semiconductor layer 22. The first transfer electrode 55, the second transfer electrode 56, and the third transfer electrode 57 are provided in the wiring layer 3.

The first transfer region 51 and the first transfer electrode 55 correspond to an end portion on a downstream side (downstream side in a direction of electric charge transfer) of the horizontal shift register 5b (see FIG. 1). The second transfer region 52 and the second transfer electrode 56 correspond to an end portion on an upstream side (upstream side in the direction of electric charge transfer) of the multiplication register 5d (see FIG. 1). The third transfer region 53 and the third transfer electrode 57 correspond to the corner register 5c.

The first transfer region 51 includes a semiconductor region 25 formed on one side of the semiconductor layer 22 in the Z-axis direction (a side opposite to the incident side of the light hv in the Z-axis direction). The second transfer region 52 includes a semiconductor region 26 formed on one side of the semiconductor layer 22 in the Z-axis direction. The semiconductor region 25 and the semiconductor region 26 are, for example, N⁺-type semiconductor regions formed in the semiconductor layer 22 by being doped with N-type impurities.

The third transfer region 53 includes a first semiconductor region 27 and a second semiconductor region 28 formed on one side of the semiconductor layer 22 in the Z-axis direction. The first semiconductor region 27 has a first impurity concentration. The second semiconductor region 28 has a second impurity concentration higher than the first impurity concentration. The first semiconductor region 27 is, for example, an N⁻-type semiconductor region formed in the semiconductor layer 22 by being doped with N-type impurities. The second semiconductor region 28 is, for example, an N-type semiconductor region formed in the semiconductor layer 22 by being doped with N-type impurities.

An end portion of the third transfer region 53 on an upstream side of the first semiconductor region 27 and the second semiconductor region 28 is connected to an end portion of the first transfer region 51 on a downstream side of the semiconductor region 25. An end portion of the third transfer region 53 on a downstream side of the first semiconductor region 27 and the second semiconductor region 28 is connected to an end portion of the second transfer region 52 on an upstream side of the semiconductor region 26. Further, in the transfer part 5, a P⁺⁺-type semiconductor region 29 in which a concentration of P-type impurities is higher than that of the P⁺ type is formed around the semiconductor region 25, the semiconductor region 26, the first semiconductor region 27, and the second semiconductor region 28.

The first transfer electrode 55 is disposed on one side of the first transfer region 51 in the Z-axis direction. That is, the first transfer electrode 55 is disposed on the first transfer region 51. The second transfer electrode 56 is disposed on one side of the second transfer region 52 in the Z-axis direction. That is, the second transfer electrode 56 is disposed on the second transfer region 52. The third transfer electrode 57 is disposed on one side of the third transfer region 53 in the Z-axis direction. That is, the third transfer electrode 57 is disposed on the third transfer region 53. The first transfer electrode 55, the second transfer electrode 56, and the third transfer electrode 57 are electrically separated by the interlayer insulating film 31. The first transfer electrode 55, the second transfer electrode 56, and the third transfer electrode 57 are formed of, for example, polysilicon.

As illustrated in FIG. 3, the first transfer region 51 transfers electric charge to one side (left side in FIG. 3) in the X-axis direction along a first line L1. The first line L1 is a straight line extending in the X-axis direction. The second transfer region 52 transfers electric charge to the other side (right side in FIG. 3) in the X-axis direction along a second line L2. The second line L2 is a straight line extending in the X-axis direction. A direction in which the second transfer region 52 transfers electric charge along the second line L2 is different from a direction in which the first transfer region 51 transfers electric charge along the first line L1. In the photoelectric conversion device 1, the direction in which the second transfer region 52 transfers electric charge along the second line L2 and the direction in which the first transfer region 51 transfers electric charge along the first line L1 form an angle of 180 degrees.

A third line L3 is deviated from both the first line L1 and the second line L2. That is, the third line L3 is deviated from the first line L1 and is deviated from the second line L2. Here, "the third line L3 is deviated from the first line L1" means that at least a part of the third line L3 is not positioned on an extension line of the first line L1 extending from a downstream end of the first line L1 (on a tangent line extending from the downstream end of the first line L1 if the first line L1 is a curve). Also, "the third line L3 is deviated from the second line L2" means that at least a part of the third line L3 is not positioned on an extension line of the second line L2 extending from an upstream end of the second line L2 (on a tangent line extending from the upstream end of the second line L2 if the second line L2 is a curve). In the photoelectric conversion device 1, the entire third line L3 is not positioned on the extension line of the first line L1 extending from the downstream end of the first line L1, and the entire third line L3 is not positioned on the extension line of the second line L2 extending from the upstream end of the second line L2.

The second line L2 is deviated from the first line L1. Here, "the second line L2 is deviated from the first line L1" means that at least a part of the second line L2 is not positioned on the extension line of the first line L1 extending from the downstream end of the first line L1 (on a tangent line extending from the downstream end of the first line L1 if the first line L1 is a curve). In the photoelectric conversion device 1, the entire second line L2 is not positioned on the extension line of the first line L1 extending from the downstream end of the first line L1.

The third transfer region 53 transfers electric charge from the first transfer region 51 side to the second transfer region 52 side along the third line L3 connected to the first line L1 and the second line L2. That is, the third transfer region 53 changes a direction of electric charge transfer from one side (left side in FIG. 3) to the other side (right side in FIG. 3) in the X-axis direction. The third line L3 is a curve (for example, an arcuate curve) connected to the first line L1 and the second line L2. In the photoelectric conversion device 1, the first line L1 and the third line L3 has a relationship in which they are in contact with each other, and the second line L2 and the third line L3 has a relationship in which they are in contact with each other.

A configuration of the third transfer region 53 will be described in more detail. As illustrated in FIG. 3, the second semiconductor region 28 extends along the third line L3 to be widened on the second transfer region 52 side. In the photoelectric conversion device 1, a width of the second semiconductor region 28 in a normal direction of the third line L3 increases as the second semiconductor region 28 comes closer to the second transfer region 52 (in other words, with distance away from the first transfer region 51). The third line L3 passes through, for example, a center in a width direction of the second semiconductor region 28. The first semiconductor region 27 is disposed on both sides of the second semiconductor region 28 in a direction in which the second semiconductor region 28 is widened (that is, a width direction of the second semiconductor region 28 in the normal direction of the third line L3). Further, a width of the second semiconductor region 28 in the normal direction of the third line L3 may increase continuously or may increase in stages.

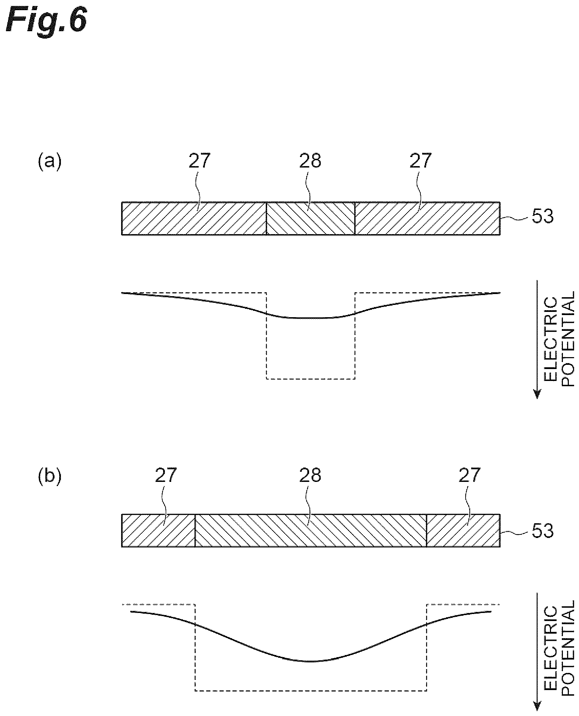

In the third transfer region 53 configured as described above, an electric potential gradient (potential energy gradient) in which electric charge moves from the first transfer region 51 side to the second transfer region 52 side is formed along the third line L3. A principle thereof is as follows. That is, in a portion of the third transfer region 53 close to the first transfer region 51, since a width of the second semiconductor region 28 with respect to a width of the third transfer region 53 is small as shown in (a) of FIG. 6, fringing from the first semiconductor regions 27 on both sides is strong, and an electric potential thereof (the solid line illustrated in (a) of FIG. 6) is shallow. On the other hand, in a portion of the third transfer region 53 close to the second transfer region 52, since a width of the second semiconductor region 28 with respect to the width of the third transfer region 53 is large as shown in (b) of FIG. 6, fringing from the first semiconductor regions 27 on both sides is weak, and an electric potential thereof (the solid line illustrated in (b) of FIG. 6) is deep. As described above, in the third transfer region 53, the second semiconductor region 28 extends along the third line L3 to be widened on the second transfer region 52 side. Therefore, in the third transfer region 53, an electric potential gradient in which electric charge moves from the first transfer region 51 side to the second transfer region 52 side is formed along the third line L3. Further, the broken lines illustrated in (a) and (b) of FIG. 6 each indicate an electric potential when the first semiconductor region 27 and the second semiconductor region 28 each exist alone.

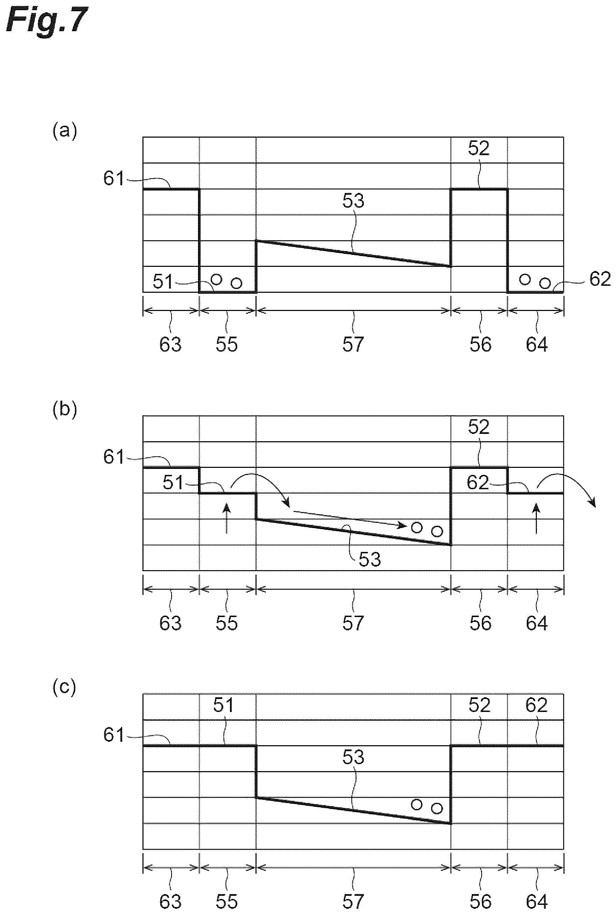

Transfer of electric charge in a portion of the transfer part 5 corresponding to the corner register 5c will be described with reference to FIGS. 7, 8, and 9. FIGS. 7, 8, and 9 are potential energy diagrams of the transfer part 5 illustrated in FIG. 3 (specifically, a portion of the transfer part 5 corresponding to the corner register 5c). Further, in the present description, a transfer region adjacent to an upstream side of the first transfer region 51 is referred to as a transfer region 61, and a transfer region adjacent to a downstream side of the second transfer region 52 is referred to as a transfer region 62. Also, a transfer electrode disposed on the transfer region 61 is referred to as a transfer electrode 63, and a transfer electrode disposed on the transfer region 62 is referred to as a transfer electrode 64.

First, from a state in which a low voltage is applied to the transfer electrode 63 and the second transfer electrode 56, a high voltage is applied to the first transfer electrode 55 and the transfer electrode 64, and a high voltage is applied to the third transfer electrode 57 as shown in (a) of FIG. 7, a low voltage is applied to the first transfer electrode 55 and the transfer electrode 64 as shown in (b) and (c) of FIG. 7. Thereby, potential energies of the first transfer region 51 and the transfer region 62 become shallow, a potential energy of the transfer region 61 serves as a barrier, and thereby electric charge (electrons) moves from the first transfer region 51 to the third transfer region 53. At this time, since an electric potential gradient (potential energy gradient) in which electric charge moves from the first transfer region 51 side to the second transfer region 52 side is formed in the third transfer region 53, the electric charge moves to the second transfer region 52 side in the third transfer region 53. Also, a potential energy of the second transfer region 52 serves as a barrier, and electric charge moves from the transfer region 62 to a transfer region (not shown) on a downstream side. Further, (b) of FIG. 7 shows a state in which the potential energies of the first transfer region 51 and the transfer region 62 are in the process of transition.

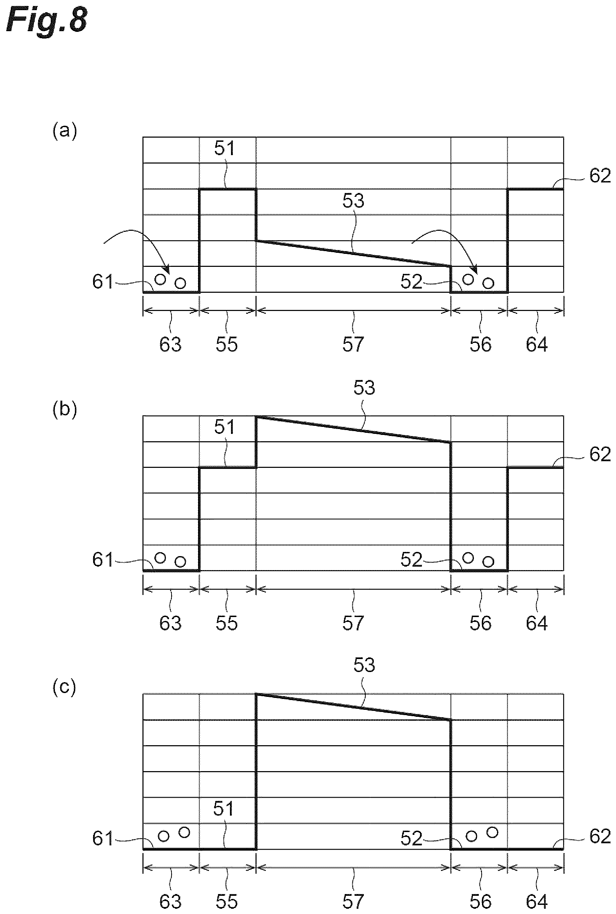

Next, a high voltage is applied to the transfer electrode 63 and the second transfer electrode 56 as shown in (a) of FIG. 8. Thereby, potential energies of the transfer region 61 and the second transfer region 52 become deeper, and electric charge moves from the third transfer region 53 to the second transfer region 52. Also, electric charge moves from a transfer region on an upstream side (not shown) to the transfer region 61. Next, a low voltage is applied to the third transfer electrode 57 as shown in (b) of FIG. 8. Thereby, a potential energy of the third transfer region 53 becomes shallow. Next, a high voltage is applied to the first transfer electrode 55 and the transfer electrode 64 as shown in (c) of FIG. 8. Thereby, the potential energies of the first transfer region 51 and the transfer region 62 become deeper.

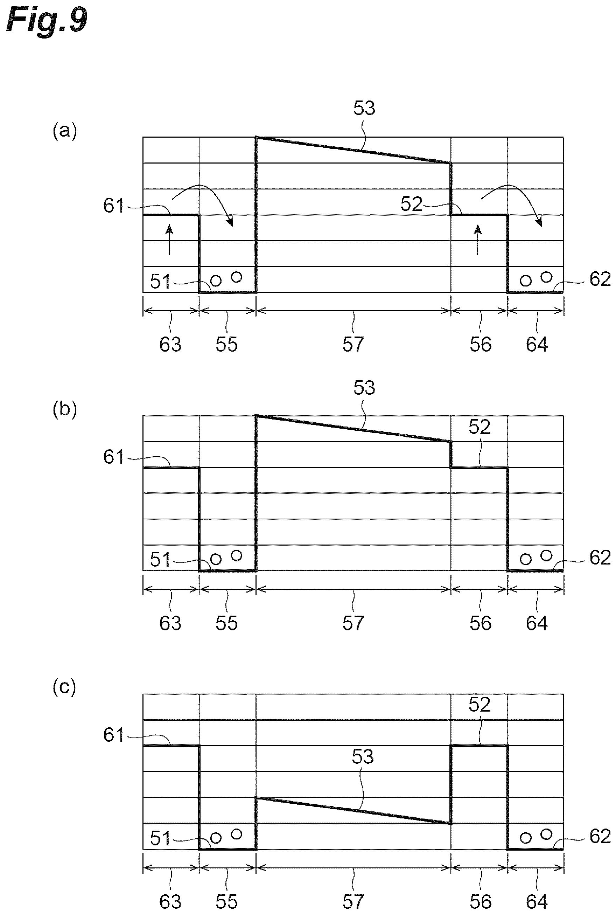

Next, a low voltage is applied to the transfer electrode 63 and the second transfer electrode 56 as shown in (a) and (b) of FIG. 9. Thereby, the potential energies of the transfer region 61 and the second transfer region 52 become shallow, the potential energy of the third transfer region 53 serves as a barrier, and thereby electric charge moves from the second transfer region 52 to the transfer region 62. Also, a potential energy of the transfer region on the upstream side serves as a barrier, and electric charge moves from the transfer region 61 to the first transfer region 51. Further, (a) of FIG. 9 shows a state in which the potential energies of the transfer region 61 and the second transfer region 52 are in the process of transition. Next, a high voltage is applied to the third transfer electrode 57 as illustrated in (c) of FIG. 9. Thereby, the potential energy of the third transfer region 53 becomes deeper, thereby returning to the state shown in (a) of FIG. 7.

### [Operation and effects]

In the photoelectric conversion device 1, the transfer part 5 (specifically, a portion of the transfer part 5 corresponding to the corner register 5c) includes the first transfer region 51 configured to transfer electric charge along the first line L1, the second transfer region 52 configured to transfer electric charge along the second line L2, and the third transfer region 53 configured to transfer electric charge from the first transfer region 51 side to the second transfer region 52 side along the third line L3 connected to the first line L1 and the second line L2, in which the third line L3 is deviated from both the first line L1 and the second line L2. Thereby, a direction of electric charge transfer or the like is changed in at least the third transfer region 53. In the third transfer region 53, the second semiconductor region 28 having the second impurity concentration higher than the first impurity concentration extends along the third line L3 to be widened on the second transfer region 52 side, and the first semiconductor region 27 having the first impurity concentration is disposed on both sides of the second semiconductor region 28 in a direction in which the second semiconductor region 28 is widened. Thereby, an electric potential gradient (potential energy gradient) in which electric charge moves from the first transfer region 51 side to the second transfer region 52 side along the third line L3 is formed in the third transfer region 53. Therefore, it is unnecessary to dispose a large number of transfer electrodes on the third transfer region 53 to change a direction of electric charge transfer or the like. Therefore, according to the photoelectric conversion device 1, in such a case in which a direction of electric charge transfer or the like is changed in the transfer part 5, the electric charge can be reliably transferred while avoiding increase in the number of transfer electrodes.

In the photoelectric conversion device 1, since increase in the number of transfer electrodes can be avoided in the transfer part 5, the following specific effects are obtained. That is, decrease in yield due to a structure thereof becoming complicated can be prevented. Also, high-speed driving being hindered due to increase in electrical capacity can be prevented. Further, increase in power consumption can be prevented.

In the photoelectric conversion device 1, a direction in which the second transfer region 52 transfers electric charge along the second line L2 is different from a direction in which the first transfer region 51 transfers electric charge along the first line L1. Thereby, a direction of electric charge transfer can be changed in the transfer part 5.

In the photoelectric conversion device 1, the third line L3 is a curve. Thereby, a direction of electric charge transfer can be smoothly changed in the transfer part 5.

In the photoelectric conversion device 1, the transfer part 5 includes the third transfer electrode 57 disposed on the third transfer region 53. Thereby, since not only electric potentials of the first transfer region 51 and the second transfer region 52 but also an electric potential of the third transfer region 53 can be controlled, the electric charge can be more reliably transferred.

In the photoelectric conversion device 1, the light-shielding layer 6 is disposed on the incident side of the light hv with respect to the transfer part 5. Thereby, unnecessary electric charge generated in the transfer part 5 due to incidence of the light hv on the transfer part 5 can be prevented.

### [Modified example]

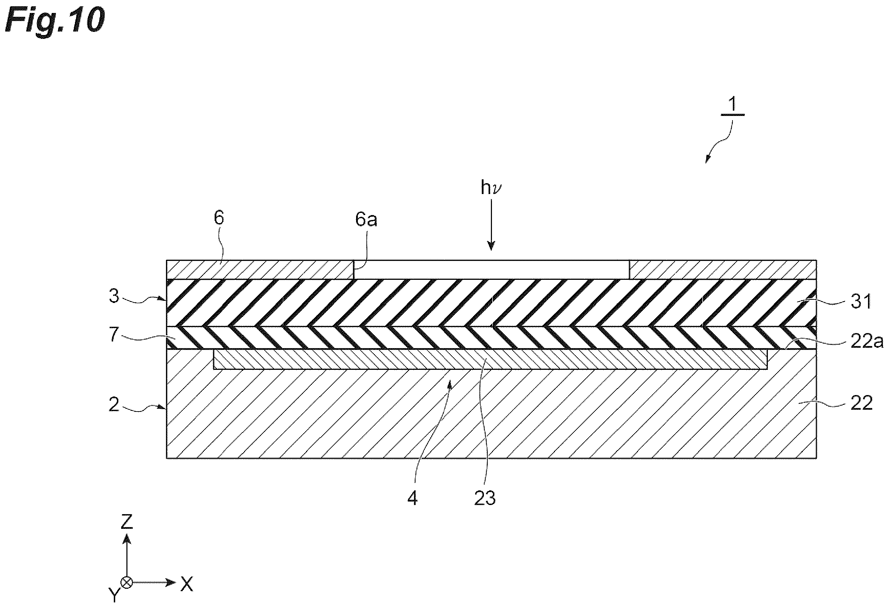

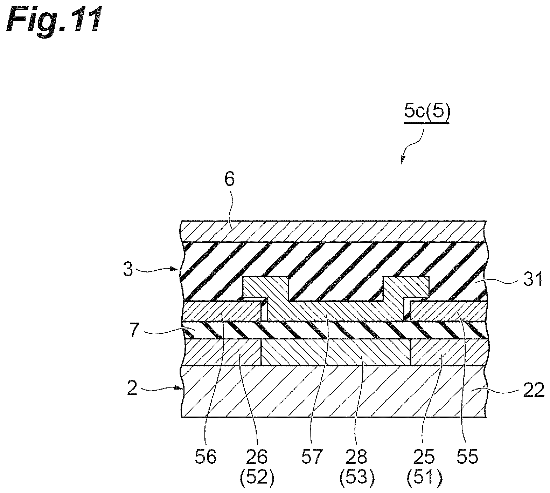

The present disclosure is not limited to the embodiment described above. For example, the photoelectric conversion device 1 may be a front-illuminated solid-state imaging device as illustrated in FIG. 10. In the photoelectric conversion device 1 illustrated in FIG. 10, a semiconductor region 23 is formed in a semiconductor layer 22 along a surface 22a of the semiconductor layer 22, and an insulating film 7, a wiring layer 3, and a light-shielding layer 6 are disposed on the surface 22a of the semiconductor layer 22 in that order. In the photoelectric conversion device 1 illustrated in FIG. 10, light hv is incident on a photoelectric conversion part 4 from the surface 22a side of the semiconductor layer 22 via an opening 6a of the light-shielding layer 6, the wiring layer 3, and the insulating film 7. The photoelectric conversion device 1 illustrated in FIG. 10 includes a transfer part 5 illustrated in FIG. 11. The transfer part 5 illustrated in FIG. 11 is different from the transfer part 5 illustrated in FIG. 4 in that a first transfer electrode 55, a second transfer electrode 56, and a third transfer electrode 57 are disposed on an incident side of the light hv with respect to a first transfer region 51, a second transfer region 52, and a third transfer region 53. Further, FIG. 11 is a cross-sectional view along a line similar to that of FIG. 4 (that is, along a line IV-IV illustrated in FIG. 3).

Also, in the photoelectric conversion device 1 illustrated in FIGS. 1 and 2, the semiconductor substrate 21 may be made thin in its entirety. In that case, the photoelectric conversion device 1 may further include a support substrate disposed on a side opposite to the incident side of the light hv with respect to the wiring layer 3.

Also, in the photoelectric conversion device 1 illustrated in FIGS. 1 and 2, in a case in which the frame portion of the semiconductor substrate 21 surrounding the recessed part 24 is disposed on the incident side of the light hv with respect to the horizontal shift register 5b, the corner register 5c, and the multiplication register 5d, the photoelectric conversion device 1 may not include the light-shielding layer 6. This is because, when the semiconductor substrate 21 includes the frame portion, even if the light hv is incident on the frame portion and electric charge is generated in the frame portion, there is a high likelihood that the electric charge will disappear before reaching the semiconductor layer 22.

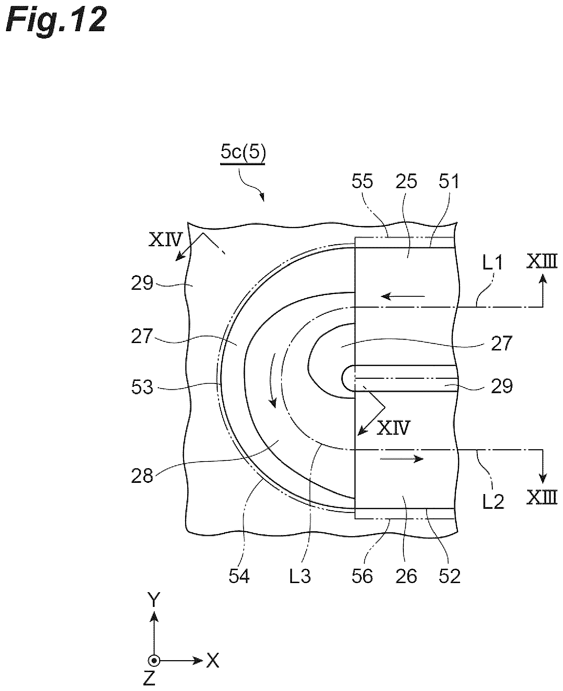

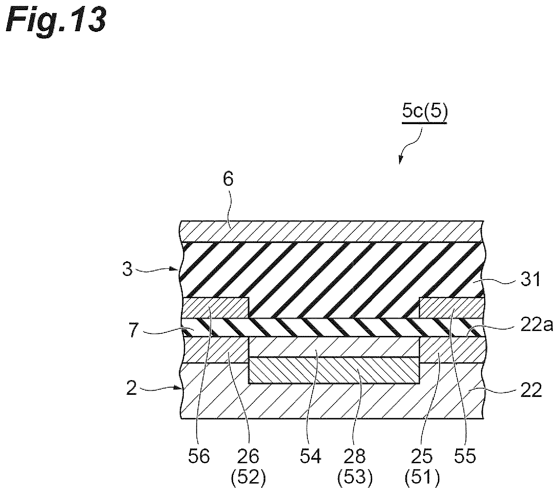

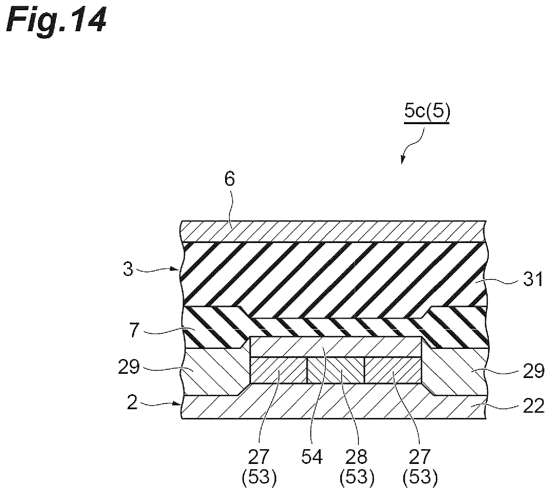

Also, the transfer part 5 may not include a transfer electrode disposed on the third transfer region 53 (a transfer electrode corresponding to the third transfer electrode 57 described above). The transfer part 5 illustrated in FIGS. 12, 13, and 14 is different from the transfer part 5 illustrated in FIG. 11 in that the transfer electrode is not disposed on the third transfer region 53, and a buried layer 54 is disposed on the third transfer region 53. In the transfer part 5 illustrated in FIGS. 12, 13, and 14, the buried layer 54 is disposed on one side of the third transfer region 53 in the Z-axis direction (incident side of the light hv in the Z-axis direction). That is, the buried layer 54 is disposed on the third transfer region 53. The buried layer 54 has a conductivity type different from conductivity types of a first semiconductor region 27 and a second semiconductor region 28. The buried layer 54 is, for example, a P⁺-type semiconductor region formed in the semiconductor layer 22 along the surface 22a of the semiconductor layer 22 by being doped with P-type impurities. According to the transfer part 5 illustrated in FIGS. 12, 13, and 14, since it is not necessary to dispose a transfer electrode on the third transfer region 53, a configuration thereof can be simplified. Also, generation of a dark current in the third transfer region 53 can be suppressed.

Also, when the transfer part 5 also functions as a photoelectric conversion part, the light-shielding layer 6 may not be disposed on a side of the transfer part 5 on which the light hv is incident regardless of whether or not the transfer part 5 has the third transfer electrode 57, and furthermore, regardless of whether or not the transfer part 5 has the buried layer 54.

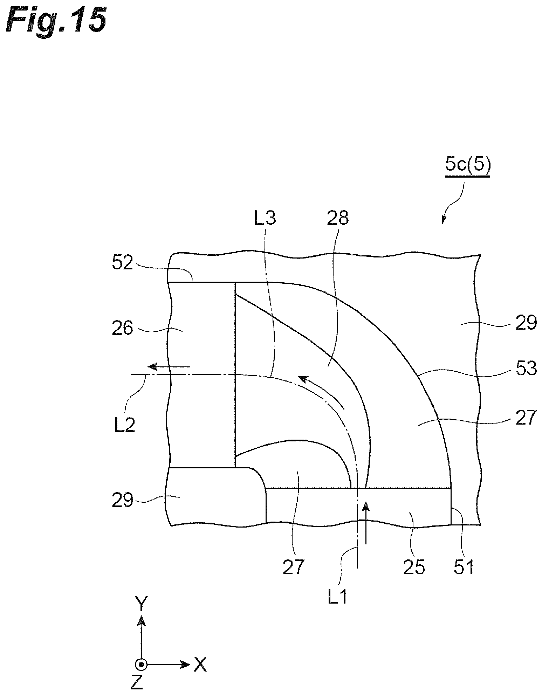

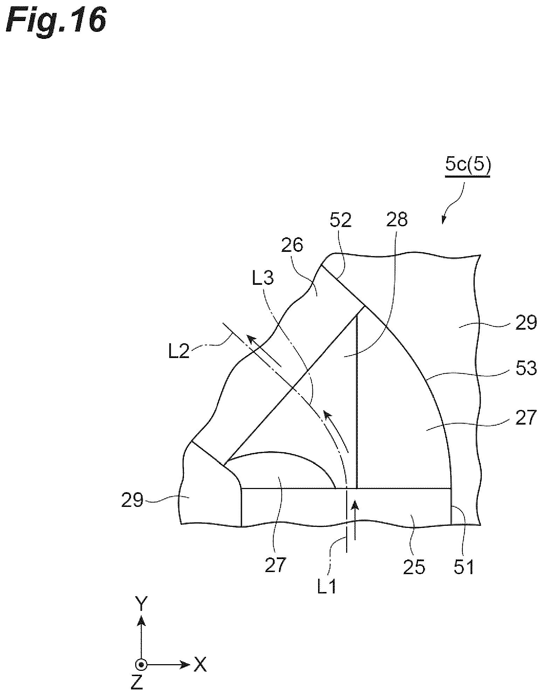

Also, a direction in which the second transfer region 52 transfers electric charge along a second line L2 need only be different from a direction in which the first transfer region 51 transfers electric charge along a first line L1. For example, as illustrated in FIG. 15, the direction in which the second transfer region 52 transfers electric charge along the second line L2 and the direction in which the first transfer region 51 transfers electric charge along the first line L1 may form an angle of 90 degrees. As illustrated in FIG. 16, the direction in which the second transfer region 52 transfers electric charge along the second line L2 and the direction in which the first transfer region 51 transfers electric charge along the first line L1 may form an angle of 45 degrees.

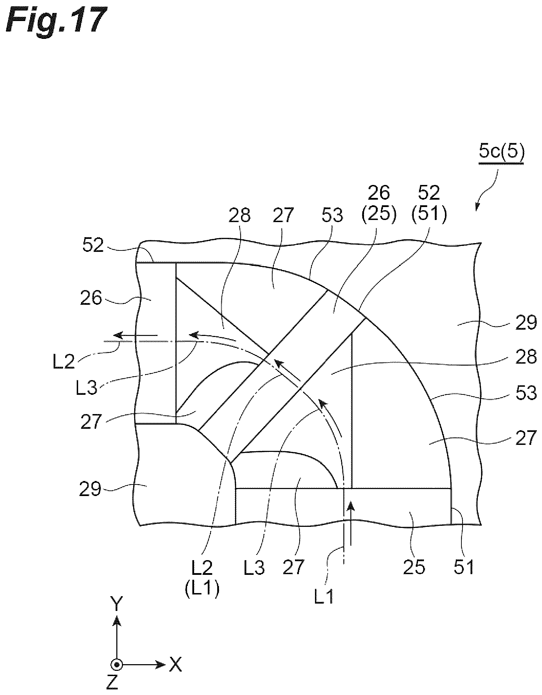

Also, as illustrated in FIG. 17, the first transfer region 51, the third transfer region 53, the second transfer region 52, the third transfer region 53, and the second transfer region 52 may be aligned in that order from an upstream side. In this case, for the third transfer region 53 on a downstream side, the second transfer region 52 adjacent, on an upstream side, to the third transfer region 53 on the downstream side corresponds to the first transfer region 51.

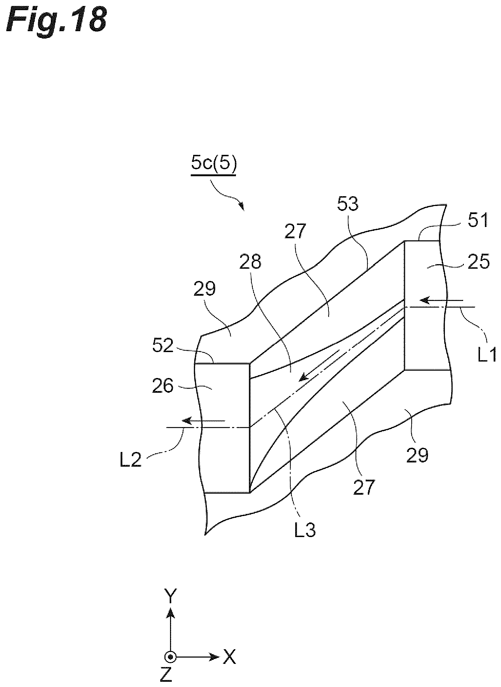

Also, if a third line L3 is deviated from at least one of the first line L1 and the second line L2, the direction in which the second transfer region 52 transfers electric charge along the second line L2 may be the same as the direction in which the first transfer region 51 transfers electric charge along the first line L1 as illustrated in FIG. 18. According to such a configuration, in such a case in which a transfer path of electric charge is changed in the transfer part 5, the electric charge can be reliably transferred while avoiding increase in the number of transfer electrodes.

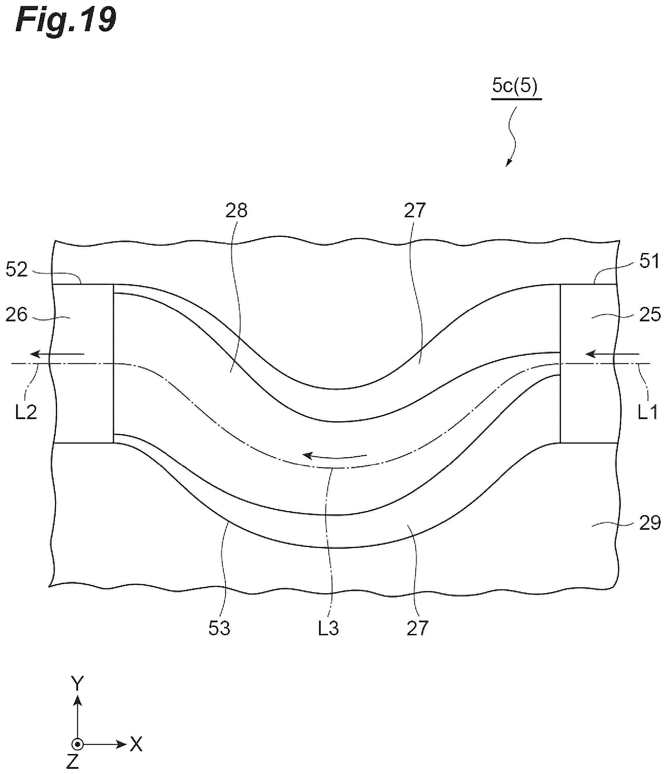

Also, if the third line L3 is deviated from at least one of the first line L1 and the second line L2, the second line L2 may not be deviated from the first line L1 as illustrated in FIG. 19. In the transfer part 5 illustrated in FIG. 19, the first line L1 and the second line L2 are positioned on the same straight line, and the third line L3 extends to deviate from the straight line and then return to the straight line. According to such a configuration, for example, in a case in which an object to be avoided by the transfer part 5 exists between the first transfer region 51 and the second transfer region 52, and the transfer part 5 cannot be formed linearly, the electric charge can be reliably transferred while avoiding increase in the number of transfer electrodes.

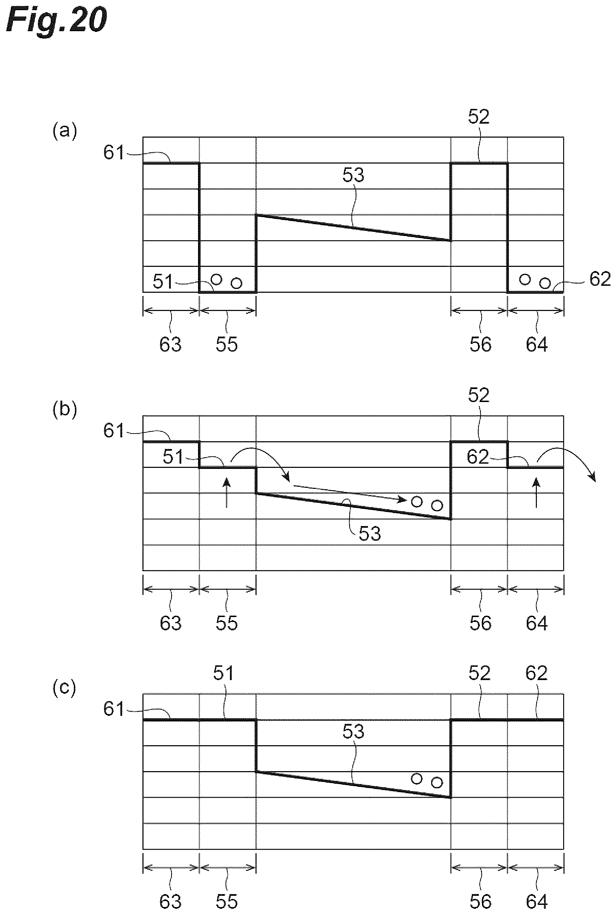

Also, transfer of electric charge at a portion of the transfer part 5 corresponding to a corner register 5c may be performed in a state in which a potential energy of the third transfer region 53 is fixed regardless of whether or not the transfer part 5 has the third transfer electrode 57. A specific example thereof will be described with reference to FIGS. 20, 21, and 22. FIGS. 20, 21, and 22 are potential energy diagrams of the transfer part 5 illustrated in FIG. 12 (specifically, a portion of the transfer part 5 corresponding to the corner register 5c). Further, in the present description, a transfer region adjacent to an upstream side of the first transfer region 51 is referred to as a transfer region 61, and a transfer region adjacent to a downstream side of the second transfer region 52 is referred to as a transfer region 62. Also, a transfer electrode disposed on the transfer region 61 is referred to as a transfer electrode 63, and a transfer electrode disposed on the transfer region 62 is referred to as a transfer electrode 64.

First, from a state in which a low voltage is applied to the transfer electrode 63 and the second transfer electrode 56 and a high voltage is applied to the first transfer electrode 55 and the transfer electrode 64 (in this state, a potential energy of the third transfer region 53 is deeper than potential energies of the transfer region 61 and the second transfer region 52 and shallower than potential energies of the first transfer region 51 and the transfer region 62) as shown in (a) of FIG. 20, a low voltage is applied to the first transfer electrode 55 and the transfer electrode 64 as shown in (b) and (c) of FIG. 20. Thereby, the potential energies of the first transfer region 51 and the transfer region 62 become shallow, a potential energy of the transfer region 61 serves as a barrier, and electric charge (electrons) moves from the first transfer region 51 to the third transfer region 53. At this time, since an electric potential gradient (potential energy gradient) in which electric charge moves from the first transfer region 51 side to the second transfer region 52 side is formed in the third transfer region 53, the electric charge moves to the second transfer region 52 side in the third transfer region 53. Also, the potential energy of the second transfer region 52 serves as a barrier, and electric charge moves from the transfer region 62 to a transfer region (not shown) on a downstream side. Further, (b) of FIG. 20 shows a state in which the potential energies of the first transfer region 51 and the transfer region 62 are in the process of transition.

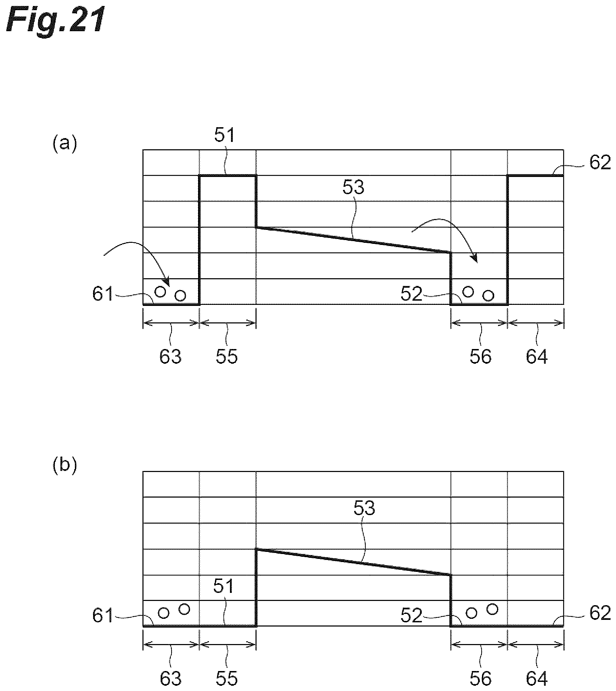

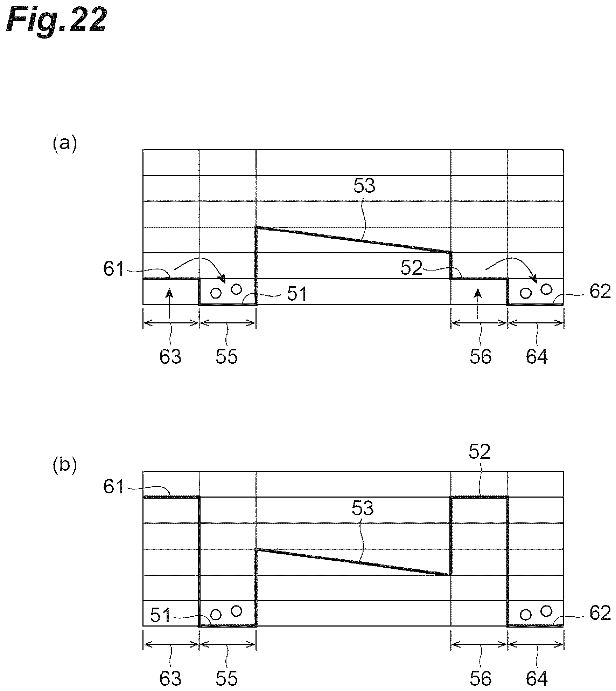

Next, a high voltage is applied to the transfer electrode 63 and the second transfer electrode 56 as shown in (a) of FIG. 21. Thereby, the potential energies of the transfer region 61 and the second transfer region 52 become deeper, and electric charge moves from the third transfer region 53 to the second transfer region 52. Also, electric charge moves from a transfer region on an upstream side (not shown) to the transfer region 61. Next, a high voltage is applied to the first transfer electrode 55 and the transfer electrode 64 as shown in (b) of FIG. 21. Thereby, the potential energies of the first transfer region 51 and the transfer region 62 become deeper. Next, a low voltage is applied to the transfer electrode 63 and the second transfer electrode 56, as illustrated in (a) and (b) of FIG. 22. Thereby, the potential energies of the transfer region 61 and the second transfer region 52 become shallow, thereby returning to the state shown in (a) of FIG. 20. Further, (a) of FIG. 22 shows a state in which the potential energies of the transfer region 61 and the second transfer region 52 are in the process of transition. In the process of this transition, the potential energy of the third transfer region 53 serves as a barrier, and thereby electric charge moves from the second transfer region 52 to the transfer region 62. Also, a potential energy of the transfer region on the upstream side serves as a barrier, and electric charge moves from the transfer region 61 to the first transfer region 51.

Also, in any of the embodiment and the example described above, an end portion of the third transfer region 53 on an upstream side of the second semiconductor region 28 may be slightly separated (to such an extent that transfer of electric charge is not hindered) from an end portion of the first transfer region 51 on a downstream side of the semiconductor region 25. Also, in any of the embodiment and the example described above, an end portion of the third transfer region 53 on a downstream side of the second semiconductor region 28 may be slightly separated (to such an extent that transfer of electric charge is not hindered) from an end portion of the second transfer region 52 on an upstream side of the semiconductor region 26. Also, in any of the embodiment and the example described above, conductivity types of the P-type and N-type may be reversed with respect to those described above. Also, in any of the embodiment and the example described above, a concentration of impurities in each of the semiconductor regions is not limited to those described above, and can be changed as appropriate.

### Reference Signs List

1 Photoelectric conversion device
4 Photoelectric conversion part
5 Transfer part
6 Light-shielding layer
27 First semiconductor region
28 Second semiconductor region
51 First transfer region
52 Second transfer region
53 Third transfer region
54 Buried layer
55 First transfer electrode
56 Second transfer electrode
57 Third transfer electrode
L1 First line
L2 Second line
L3 Third line

## Claims

1. A photoelectric conversion device (1) comprising:
a photoelectric conversion part (4) configured to generate electric charge according to incidence of light; and a transfer part (5) configured to transfer the electric charge,
wherein the transfer part (5) includes: a first transfer region (51) configured to transfer the electric charge along a first line; a second transfer region (52) configured to transfer the electric charge along a second line; a third transfer region (53) configured to transfer the electric charge from the first transfer region (51) side to the second transfer region (52) side along a third line (L3) connected to the first line (L1) and the second line (L2); a first transfer electrode (55) disposed on the first transfer region (51) ; and a second transfer electrode (56) disposed on the second transfer region (52) , the third line (L3) is deviated from at least one of the first line (L1) and
the second line (L2), the third transfer region (53) includes: a first semiconductor region (27) having a first impurity concentration; and a second semiconductor region (28) having a second impurity concentration higher than the first impurity concentration, the second semiconductor region (28) extends along the third line (L3) to be widened on the second transfer region (52) side, and the first semiconductor region (27) is disposed on both sides of the second semiconductor region (28) in a direction in which the second semiconductor region (28) is widened.

2. The photoelectric conversion device according to claim **1,** wherein a direction in which the second transfer region transfers the electric charge along the second line is different from a direction in which the first transfer region transfers the electric charge along the first line.

3. The photoelectric conversion device according to claim 1 or 2, wherein the third line is a curve.

4. The photoelectric conversion device according to any one of claims 1 to 3, wherein the transfer part further includes a third transfer electrode disposed on the third transfer region.

5. The photoelectric conversion device according to any one of claims 1 to 3, wherein
the transfer part further includes a buried layer having a conductivity type different from conductivity types of the first semiconductor region and the second semiconductor region, and
the buried layer is disposed on the third transfer region.

6. The photoelectric conversion device according to any one of claims 1 to 5, further comprising a light-shielding layer disposed on an incident side of the light with respect to the transfer part.

## Patentansprüche

1. Photoelektrische Umwandlungsvorrichtung (1), umfassend:
ein photoelektrisches Umwandlungselement (4), das dazu konfiguriert ist, entsprechend dem Lichteinfall elektrische Ladung zu erzeugen; und ein Übertragungselement (5), das dazu konfiguriert ist, die elektrische Ladung zu übertragen, wobei das Übertragungselement (5) Folgendes einschließt: einen ersten Übertragungsbereich (51), der dazu konfiguriert ist, die elektrische Ladung entlang einer ersten Leitung zu übertragen; einen zweiten Übertragungsbereich (52), der dazu konfiguriert ist, die elektrische Ladung entlang einer zweiten Leitung zu übertragen; einen dritten Übertragungsbereich (53), der dazu konfiguriert ist, die elektrische Ladung von der Seite des ersten Übertragungsbereichs (51) zur Seite des zweiten Übertragungsbereichs (52) entlang einer dritten Leitung (L3) zu übertragen, die mit der ersten Leitung (L1) und der zweiten Leitung (L2) verbunden ist; eine erste Übertragungselektrode (55), die auf dem ersten Übertragungsbereich (51) angeordnet ist; und eine zweite Übertragungselektrode (56), die auf dem zweiten Übertragungsbereich (52) angeordnet ist, wobei die dritte Leitung (L3) von mindestens einer der ersten Leitung (L1) und der zweiten Leitung (L2) abweicht, wobei der dritte Übertragungsbereich (53) Folgendes einschließt: einen ersten Halbleiterbereich (27), der eine erste Verunreinigungskonzentration aufweist; und einen zweiten Halbleiterbereich (28), der eine zweite Verunreinigungskonzentration aufweist, die höher ist als die erste Verunreinigungskonzentration, wobei sich der zweite Halbleiterbereich (28) entlang der dritten Leitung (L3) erstreckt, um auf der Seite des zweiten Übertragungsbereichs (52) verbreitert zu werden, und der erste Halbleiterbereich (27) auf beiden Seiten des zweiten Halbleiterbereichs (28) in einer Richtung angeordnet ist, in der der zweite Halbleiterbereich (28) verbreitert ist.

2. Photoelektrische Umwandlungsvorrichtung nach Anspruch 1, wobei eine Richtung, in der der zweite Übertragungsbereich die elektrische Ladung entlang der zweiten Leitung überträgt, sich von einer Richtung unterscheidet, in der der erste Übertragungsbereich die elektrische Ladung entlang der ersten Leitung überträgt.

3. Photoelektrische Umwandlungsvorrichtung nach Anspruch 1 oder 2, wobei die dritte Leitung eine Kurve ist.

4. Photoelektrische Umwandlungsvorrichtung nach einem der Ansprüche 1 bis 3, wobei das Übertragungselement weiter eine dritte Übertragungselektrode einschließt, die in dem dritten Übertragungsbereich angeordnet ist.

5. Photoelektrische Umwandlungsvorrichtung nach einem der Ansprüche 1 bis 3, wobei
das Übertragungselement weiter eine Einbettungsschicht einschließt, die einen Leitfähigkeitstyp aufweist, der sich von den Leitfähigkeitstypen des ersten Halbleiterbereichs und des zweiten Halbleiterbereichs unterscheidet, und
die Einbettungsschicht auf dem dritten Transferbereich angeordnet ist.

6. Photoelektrische Umwandlungsvorrichtung nach einem der Ansprüche 1 bis 5, weiter umfassend eine Lichtabschirmschicht, die auf einer Einfallsseite des Lichts in Bezug auf das Übertragungselement angeordnet ist.

## Revendications

1. Dispositif de conversion photoélectrique (1) comprenant :
une partie de conversion photoélectrique (4) configurée pour générer une charge électrique en fonction de l'incidence de la lumière ; et une partie de transfert (5) configurée pour transférer la charge électrique, dans lequel la partie de transfert (5) inclut : une première région de transfert (51) configurée pour transférer la charge électrique le long d'une première ligne ; une deuxième région de transfert (52) configurée pour transférer la charge électrique le long d'une deuxième ligne ; une troisième région de transfert (53) configurée pour transférer la charge électrique depuis le côté de première région de transfert (51) jusqu'au côté de deuxième région de transfert (52) le long d'une troisième ligne (L3) reliée à la première ligne (L1) et la deuxième ligne (L2) ; une première électrode de transfert (55) disposée sur la première région de transfert (51) ; et une deuxième électrode de transfert (56) disposée sur la deuxième région de transfert (52), la troisième ligne (L3) est déviée à partir d'au moins une ligne parmi la première ligne (L1) et la deuxième ligne (L2), la troisième région de transfert (53) inclut : une première région semi-conductrice (27) présentant une première concentration d'impuretés ; et une seconde région semi-conductrice (28) présentant une seconde concentration d'impuretés supérieure à la première concentration d'impuretés, la seconde région semi-conductrice (28) s'étend le long de la troisième ligne (L3) pour être élargie sur le côté de deuxième région de transfert (52), et la première région semi-conductrice (27) est disposée des deux côtés de la seconde région semi-conductrice (28) dans une direction où la seconde région semi-conductrice (28) est élargie.

2. Dispositif de conversion photoélectrique selon la revendication 1, dans lequel une direction dans laquelle la deuxième région de transfert transfère la charge électrique le long de la deuxième ligne est différente d'une direction dans laquelle la première région de transfert transfère la charge électrique le long de la première ligne.

3. Dispositif de conversion photoélectrique selon la revendication 1 ou 2, dans lequel la troisième ligne est une courbe.

4. Dispositif de conversion photoélectrique selon l'une quelconque des revendications 1 à 3, dans lequel la partie de transfert inclut en outre une troisième électrode de transfert disposée sur la troisième région de transfert.

5. Dispositif de conversion photoélectrique selon l'une quelconque des revendications 1 à 3, dans lequel
la partie de transfert inclut en outre une couche enterrée présentant un type de conductivité différent des types de conductivité de la première région semi-conductrice et de la seconde région semi-conductrice, et
la couche enterrée est disposée sur la troisième région de transfert.

6. Dispositif de conversion photoélectrique selon l'une quelconque des revendications 1 à 5, comprenant en outre une couche de protection contre la lumière disposée sur un côté incident de la lumière par rapport à la partie de transfert.
